# FASCICULE DE BREVET EUROPEEN

(11) **EP 0 338 899 B1**
(45) Date de publication et mention de la délivrance du brevet: **08.09.1993**
(21) Numéro de dépôt: 89401030.5
(22) Date de dépôt: 14.04.1989
(51) Int. Cl.: H04N 7/13

(54) **Procédé de codage et de décodage d'informations, par blocs, et dispositifs de codage et de décodage pour la mise en oeuvre de ce procédé**
Verfahren zur Kodierung und Dekodierung von Blockinformationen und Vorrichtung dazu
Method for coding and decoding blocks of data and apparatus for carrying out said coding and decoding method

(30) Priorité: 15.04.1988 FR 8805021
(43) Date de publication de la demande: 25.10.1989
(73) Titulaire: THOMSON-CSF, 75008 Paris (FR)
(72) Inventeur: Perron, Claude, F-92045 Paris la Défense (FR); Tourtier, Philippe, F-92045 Paris la Défense (FR)
(74) Mandataire: Lincot, Georges

(56) Documents cités:
- US-A- 4 694 336

## Description

L'invention concerne un procédé de codage et de décodage d'informations, par blocs, chaque bloc étant constitué d'un nombre fixé de mots d'informations comportant chacun n bits, au maximum ; et concerne un dispositif de codage, et un dispositif de décodage pour la mise en oeuvre de ce procédé.

Les blocs peuvent être, par exemple, des tableaux de 8x8 ou de 16x16 coefficients de transformation cosinus résultant du codage d'une suite d'images par la transformation cosinus. Un tel tableau comporte de nombreux coefficients nuls. Les coefficients non nuls ont des probabilités d'apparition qui décroissent en fonction de la valeur absolue des coefficients. Classiquement, ces coefficients sont codés par un codage à longueur variable, tel qu'un codage de Huffmann qui consiste à représenter par des mots de code plus courts les coefficients ayant les probabilités d'apparition les plus fortes. Un codage de Huffmann est efficace s'il y a une grande différence entre les probabilités d'apparition des valeurs les plus fréquentes et celles des valeurs les moins fréquentes. Par contre, ce type de codage n'est pas efficace pour coder des mots qui ont des probabilités d'apparition peu différentes.

Un autre type de codage à longueur variable est décrit dans Picture Coding Symposium PCS86, Tokyo, Japan, 2-4 april 1986, pages 148-149 ; et consiste à ;
- réorganiser la suite des mots d'informations constituant chaque bloc, en classant les mots dans n classes n° i, pour i=1 à n, la classe n° i regroupant tous les mots ayant i bits significatifs ;
- transmettre les mots de valeur non nulle, de chaque classe n°i, pour i=1 à n successivement, en omettant de transmettre le bit significatif de plus fort poids, et chaque mot transmis étant accompagné d'une adresse repérant la position du mot dans son bloc. Cette adresse est une adresse relative calculée en soustrayant, à l'adresse absolue du mot à coder, l'adresse absolue du dernier mot ayant été codée précédemment dans la même classe que le mot à coder. Puis cette adresse relative est codée par un codage de Huffmann.

Le décodage consiste successivement, pour chaque classe n° i, pour i=1 à n, et pour chaque mot d'informations transmis, à :
- reconstituer le bit significatif de plus fort poids ;
- déduire l'adresse absolue de chaque mot d'informations transmis, à partir de son adresse codée ;
et consiste à reconstituer le bloc de mots d'informations à partir des mots transmis, ainsi reconstitués, et à partir de leurs adresses absolues, en insérant des mots de valeur nulle, aux adresses absolues pour lesquelles aucun mot n'a été transmis.

Le but de l'invention est de proposer un procédé de codage perfectionnant ce procédé connu, pour réduire encore plus le débit des informations transmises. L'objet de l'invention est un procédé consistant à coder les adresses absolues repérant la position des mots d'informations dans un bloc, en calculant une adresse relative, comme dans le procédé connu, puis à réduire la valeur de cette adresse relative en lui soustrayant un nombre qui est inférieur à la valeur de l'adresse relative et qui peut être déterminé, au moment du décodage, sans avoir à le transmettre.

Ce procédé a pour avantage de réduire la quantité d'informations à transmettre en réduisant la valeur des adresses relatives ; et de pouvoir être mis en oeuvre au moyen d'un dispositif simple et pouvant fonctionner en temps réel pour des images de télévision classique. La longueur moyenne des mots de code obtenus par ce procédé est proche du nombre minimal théorique, dans le cas où les mots de données à transmettre ont une distribution statistique dispersée.

Selon l'invention, un procédé de codage et de décodage d'informations, par blocs, chaque bloc étant constitué d'un nombre fixé de mots d'informations comportant chacun n bits, au maximum ; et la position des mots dans chaque bloc étant repérée par une suite d'adresses, dites absolues, ayant des valeurs consécutives ;
le codage consistant à :
- classer les mots dans n classes n°i pour i=1 à n, la classe n°i regroupant tous les mots ayant i bits significatifs ;
- transmettre, classe par classe, et dans l'ordre des adresses absolues croissantes, les mots qui ont une valeur non nulle, en omettant le bit significatif de plus fort poids, et chaque mot étant accompagné d'une adresse dite adresse transmise, codée par un code à longueur variable ; le décodage consistant à :
- stocker, classe par classe, les mots et leurs adresses transmises ;
- reconstituer le bit significatif de plus fort poids, de chaque mot ;
- reconstituer l'adresse absolue de chaque mot transmis, à partir de son adresse transmise ;
- reconstituer un bloc de mots d'informations, à partir des mots dont la valeur et l'adresse absolue ont été reconstituées, en insérant des mots de valeur nulle aux adresses absolues pour lesquelles aucun mot n'a été transmis ;
est caractérisé en ce que pour déterminer chaque adresse transmise, le codage consiste à calculer une adresse dite relative, en soustrayant, à l'adresse absolue du mot à coder, l'adresse absolue du dernier mot ayant été codé précédemment dans la même classe ; puis à calculer une adresse transmise, en soustrayant, à l'adresse relative, le nombre des mots qui ont été codés entre le mot à coder et le dernier mot précédemment codé dans la même classe, et qui appartiennent à une classe ayant un numéro inférieur à celui de la classe du mot à coder ;
et en ce que pour reconstituer l'adresse absolue de chaque mot transmis, à partir de son adresse transmise, le décodage consiste à :
- calculer une adresse relative hypothétique pour le premier mot non encore décodé dans chaque classe n°i, pour i=1 à n, en additionnant à l'adresse transmise avec ce mot, le nombre des mots qui ont été décodés entre le mot à décoder et le dernier mot précédemment décodé dans la même classe, et qui appartiennent à une classe ayant un numéro inférieur à celui de la classe du mot à décoder ;
- puis calculer une adresse absolue hypothétique, pour le premier mot non encore décodé dans chaque classe, en additionnant son adresse relative hypothétique et l'adresse absolue du dernier mot décodé précédemment dans la même classe du mot ;
- sélectionner l'adresse absolue hypothétique ayant la valeur minimale, en sélectionnant éventuellement l'adresse absolue hypothétique correspondant à la classe de numéro minimal, s'il y a plusieurs mots ayant la même adresse absolue hypothétique minimale, l'adresse sélectionnée constituant l'adresse absolue décodée du mot correspondant.

L'invention sera mieux comprise et d'autres détails apparaîtront à l'aide de la description ci-dessous et des figures l'accompagnant :
- la figure 1 représente un exemple de bloc de 8x8 coefficients de transformation cosinus, à coder par le procédé selon l'invention ;
- la figure 2 représente l'ordre de balayage pour définir une suite d'adresses absolues consécutives repérant la position des coefficients de transformation dans le bloc ;
- la figure 3 représente un tableau des adresses absolues des coefficients de transformation dans le bloc ;
- la figure 4 représente la répartition des coefficients de transformation du bloc de la figure 1, dans trois classes : n°1, n°2, n°3 ;
- la figure 5 illustre les différentes étapes du codage des coefficients de transformation dans cet exemple ;
- la figure 6 illustre les différentes étapes du décodage des coefficients de transformation dans cet exemple ;
- la figure 7 représente le schéma synoptique d'un exemple de réalisation du dispositif de codage selon l'invention ;
- la figure 8 représente le schéma synoptique d'un exemple de réalisation du dispositif de décodage selon l'invention.

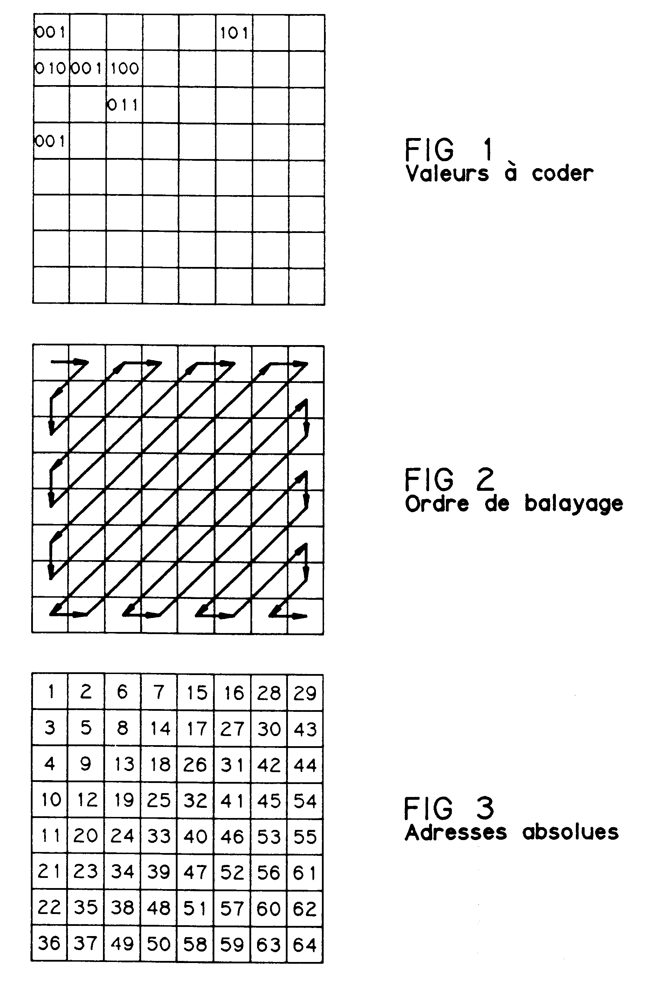

Le bloc de mots d'informations à coder, représenté sur la figure 1, est un bloc de 8x8 coefficients de transformation cosinus résultant de la transformation d'un bloc de 8x8 éléments d'image. Les valeurs nulles sont représentées par des blancs. Les coefficients situés en haut, à gauche du tableau, correspondent aux basses fréquences spatiales de l'image alors que les coefficients situés en bas, à droite, correspondent aux hautes fréquences spatiales, et ont en général des valeurs nulles. Les coefficients sont considérés successivement selon un chemin de balayage prédéterminé, ce qui permet de les traiter successivement comme s'il s'agissait d'un tableau à une seule dimension. Pour que la suite des coefficients se termine par une longue plage de valeurs nulles, le chemin de balayage choisi a une forme en zigzag telle que celle représentée sur la figure 2.

La figure 3 représente le tableau des adresses absolues des coefficients de transformation de la figure 1, balayés dans l'ordre de balayage représenté sur la figure 2.

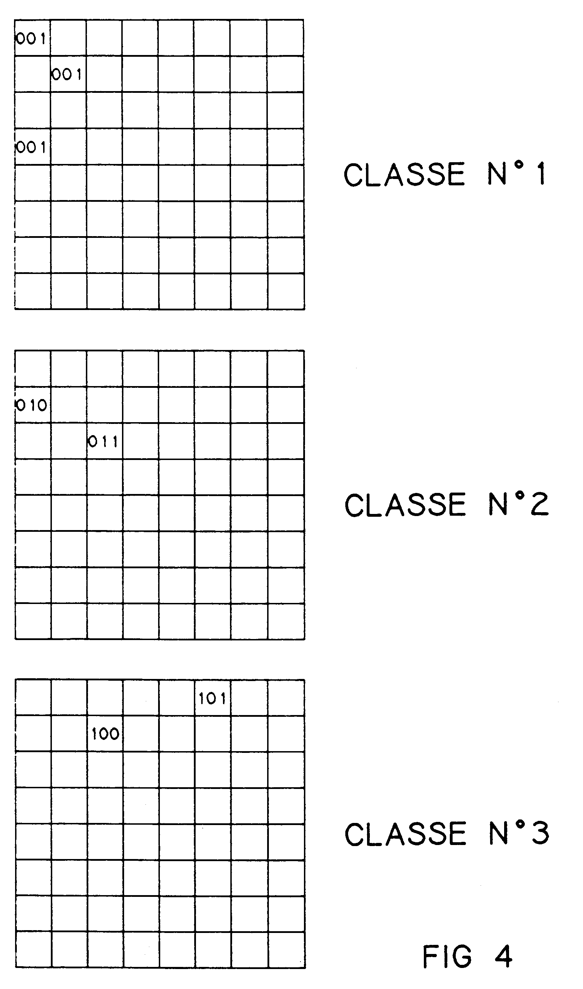

Dans cet exemple, les mots à coder ont 3 bits, au maximum. Une première étape du procédé selon l'invention consiste à classer les coefficients dans trois classes : n°1, n°2, n°3, regroupant respectivement les coefficients ayant : un seul bit significatif ; deux bits significatifs ; trois bits significatifs. Chacune de ces classes peut être représentée par un tableau de dimensions 8x8. La figure 4 représente les classes n°1, n°2, et n°3.

Les coefficients non nuls sont transmis en clair, classe après classe, dans l'ordre des numéros croissant, en omettant de transmettre le bit significatif de plus fort poids, puisqu'il est le même pour tous les coefficients d'une même classe. Puisque les coefficients non nuls ne sont pas transmis, il est nécessaire de transmettre une adresse repérant la position de chaque coefficient qui est transmis. Pour réduire la quantité d'informations transmises, il est envisageable de coder cette adresse par un codage de Huffmann. Mais pour que ce codage de Huffmann soit efficace il ne faut pas transmettre les adresses absolues car elles sont toutes différentes les unes des autres, ce qui interdit tout efficacité au codage de Huffmann. Une adresse relative obtenue en calculant la différence entre l'adresse absolue du coefficient à transmettre et l'adresse absolue du précédent coefficient transmis, a l'avantage d'être d'autant plus petite que les deux coefficients considérés sont proches dans le bloc. Mais il est possible d'améliorer encore le codage des adresses en réduisant la valeur de l'adresse relative, pour réduire la quantité d'informations à transmettre.

Pour cela, le procédé selon l'invention consiste à réduire la valeur de l'adresse relative en soustrayant à cette adresse relative le nombre de coefficients ayant été codés dans toutes les autres classes ayant un numéro inférieur à celui de la classe du coefficient à coder, entre l'instant considéré et l'instant où a été codé le coefficient dont l'adresse sert de référence pour le calcul de l'adresse relative, c'est-à-dire depuis le codage du dernier coefficient ayant été précédemment codé, dans la même classe que le coefficient à coder.

Quand tous les coefficients d'une classe ont été codés, le procédé consiste ensuite à coder successivement les coefficients de valeur non nulle appartenant à la classe suivante, les classes étant considérées dans l'ordre des numéros croissants qui correspond aussi à des coefficients ayant un nombre de bits significatifs croissant. Comme il apparaîtra dans la suite de la description de cet exemple, le choix de cet ordre de priorité pour le codage successif des classes, permet de réduire plus efficacement les valeurs des adresses relatives, parce que les classes de faibles numéros comportent un plus grand nombre de coefficients non nuls que les classes de numéros élevés.

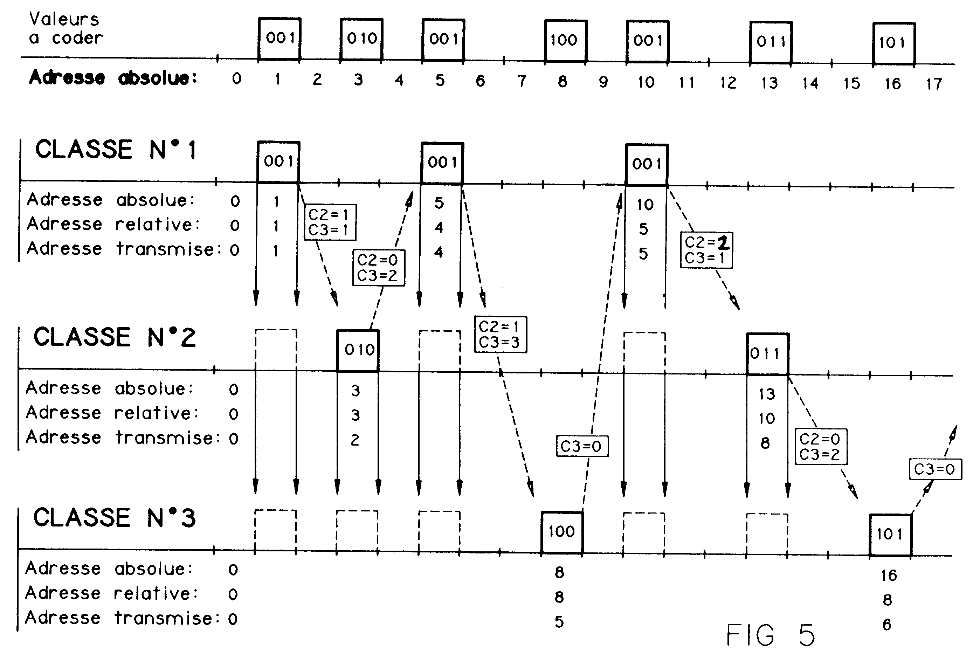

La figure 5 illustre le codage de cet exemple de bloc de 8x8 coefficients. La première ligne représente la suite de ses coefficients et leurs adresses absolues respectives, lorsqu'ils sont balayés dans l'ordre représenté sur la figure 2. La deuxième ligne représente les coefficients appartenant à la classe n°1. Ces coefficients ont un seul bit significatif. Il n'y a qu'une seule valeur qui apparaît et qui est la valeur 001. La troisième ligne représente les coefficients de la classe n°2. La quatrième ligne représente les coefficients de la classe n°3. En dessous de chaque coefficient, sont représentées successivement : la valeur de son adresse absolue ; la valeur de son adresse relative, par rapport au dernier coefficient précédemment codé dans la même classe ; et enfin la valeur de son adresse transmise, qui est calculée à partir de l'adresse relative située au-dessus.

Les flèches en pointillés représentent l'ordre dans lequel sont codés successivement les coefficients. Cet ordre correspond aux adresses absolues croissantes. Une adresse absolue 0, fictive, a été rajoutée pour permettre de calculer une adresse relative et une adresse transmise, pour le coefficient ayant une adresse absolue égale à 1, selon le même processus de calcul que pour les autres coefficients.

Par construction des classes, un coefficient n'appartient qu'à une classe. Dans les autres classes, la même adresse absolue ne contient aucun coefficient.

Sur la figure 5, des carrés en pointillés représentent des informations déduites du fait qu'il existe un coefficient non nul dans une classe ayant un numéro plus faible que celui de la classe où est placé le carré en pointillés. Cette information est utilisée pour réduire la valeur de chaque adresse relative et obtenir une adresse transmise, pour un coefficient de la classe où est placé le carré en pointillés. Réciproquement, cette information est utilisée au décodage pour retrouver l'adresse relative à partir de l'adresse transmise, avant d'en déduire l'adresse absolue.

Par exemple, la présence du coefficient 001 à l'adresse absolue 1 dans la classe n°1 permet d'affirmer qu'il y a sûrement une absence de coefficient à l'adresse absolue 1 dans la classe n°2 et dans la classe n°3. De même, la présence du coefficient 010 à l'adresse absolue 3 dans la classe n°2 permet d'affirmer qu'il y a sûrement une absence de coefficient à l'adresse absolue 3 dans la classe n°3 notamment. De même, la présence du coefficient 001 à l'adresse absolue 5 dans la classe n°1 permet d'affirmer qu'il y a sûrement une absence de coefficient dans la classe n°2 et dans la classe n°3, à l'adresse absolue 5.

Ces absences de coefficients sont connues du décodeur sans avoir à les transmettre. Le procédé selon l'invention exploite ces informations qui sont redondantes. Par exemple, lors du codage du coefficient 100, à l'adresse absolue 8 de la classe 3, l'adresse relative de ce coefficient est aussi égale à 8, car il n'y a pas eu d'autres coefficients non nuls codés précédemment dans cette classe. Cette adresse relative peut être diminuée de trois unités, correspondant aux 3 carrés en pointillés, à partir du moment où il est connu par ailleurs qu'il y a ces 3 adresses vides dans cette classe n°3, entre l'adresse absolue 0 et l'adresse absolue 8.

Pour pouvoir calculer de cette manière l'adresse transmise d'un coefficient non nul, il est nécessaire de connaître le nombre de coefficients non nuls ayant été codés dans les classes de numéros inférieurs à celui de la classe considérée, entre l'instant considéré et l'instant où a été codé le précédent coefficient non nul dans la même classe. Le procédé consiste à prendre en compte les valeurs de deux variables C2 et C3 qui comptent respectivement dans les classes n°2 et n°3, le nombre que l'on peut soustraire à l'adresse relative du prochain coefficient à coder. C2 est le contenu d'un compteur qui est remis à zéro chaque fois qu'un coefficient non nul est codé dans la classe n°2 et qui est incrémenté chaque fois qu'un coefficient non nul de la classe n°1 est codé. C3 est le contenu d'un compteur qui est remis à zéro chaque fois qu'un coefficient non nul est codé dans la classe n°3 et qui est incrémenté d'une unité chaque fois qu'un coefficient non nul est codé dans la classe n°1 ou dans la classe n°2. En règle générale le compteur de la classe n°i est remis à zéro lorsqu'un coefficient non nul de la classe n°i est codé, et il est incrémenté d'une unité chaque fois qu'un coefficient non nul est codé dans l'une des classes ayant un numéro strictement inférieur à i. Naturellement, il n'y a pas de variable C1 correspondant à la classe n°1, puisqu'il n'y a pas de classe ayant un numéro inférieur à 1. En outre, dans la classe n°1 chaque adresse transmise est égale à l'adresse relative correspondante.

La figure 5 montre l'évolution des valeurs C2 et C3 lors du codage de chacun des coefficients non nuls, le long du trajet représenté par les flèches en pointillés. Par exemple, la valeur C3 est incrémentée lors du codage du coefficient 001 situé à l'adresse absolue 1 et appartenant à la classe n°1, puis est incrémentée lors du codage du coefficient 010 situé à l'adresse absolue 3 et appartenant à la classe n°2 ; puis est incrémentée lors du codage du coefficient 001 situé à l'adresse absolue 5 et appartenant à la classe n°1. La valeur C3 est remise à zéro lors du codage de la valeur 100 située à l'adresse absolue 8 et appartenant à la classe n°3, après que la valeur 3 de C3 ait été utilisée pour calculer l'adresse transmise avec ce coefficient.

La présence d'un coefficient non nul à une adresse donnée, dans une classe n°i, permet aussi de conclure qu'il n'y a sûrement une absence de coefficient à cette même adresse dans les classes de numéros strictement inférieurs à i, mais cette information n'est pas exploitée pour réduire la valeur des adresses relatives, car l'adresse relative ne pourrait pas être reconstituée à partir de l'adresse transmise, au moment du décodage, comme cela apparaîtra au cours de la description du décodage dans ce qui suit.

La classe n°1 correspond aux coefficients ayant les plus faibles valeurs : 001, qui sont ceux ayant la plus grande probabilité d'apparition. Le fait de donner la priorité aux classes dans l'ordre n°1, n°2, n°3 etc, plutôt que dans l'ordre inverse, permet aux variables Cᵢ d'atteindre des valeurs plus élevées et permet donc de réduire plus les valeurs des adresses transmises, ce qui réduit la quantité d'informations à transmettre. Cela apparaît sur la figure 5 : les coefficients de la classe n°1 sont plus nombreux que ceux des classes n°2 et n°3, donc leurs adresses relatives et leurs adresses transmises sont plus petites. D'autre part, les valeurs C2 et C3 sont relativement élevées, ce qui se traduit sur la figure par un grand nombre de carrés en pointillés ; et ce qui se traduit par une réduction des valeurs des adresses transmises pour les classes n°2 et n°3.

Dans cet exemple de mise en oeuvre, les adresses transmises sont codées par un codage de Huffmann avant leur transmission. Elles sont fortement groupées statistiquement au voisinage de la valeur 1, ce qui permet un codage de Huffmann efficace.

Les coefficients et les adresses correspondant à deux blocs distincts sont transmis en les séparant par un séparateur inter-blocs choisi tel qu'il est inimitable par une concaténation licite des coefficients et des adresses.

Naturellement les données codées correspondant à des classes distinctes doivent être séparées pour permettre, au moment du décodage, de distinguer les coefficients appartenant aux différentes classes. Le procédé selon l'invention comporte deux variantes dont une première consiste à transmettre, avec les coefficients et avec les adresses de chaque classe, un mot séparateur inter-classes choisi tel qu'il est inimitable par une concaténation licite des coefficients et des adresses transmises, celles-ci étant codées par un code de Huffmann. Selon une seconde variante du procédé, celui-ci consiste à transmettre avant les coefficients et les adresses de chaque classe, un mot binaire donnant le nombre de coefficients non nuls transmis.

Le décodage a pour but de restituer la valeur exacte de chaque coefficient et son adresse absolue. La reconstitution des coefficients non nuls est très simple puisqu'il suffit d'adjoindre un bit significatif supplémentaire aux valeurs transmises. Par contre, la reconstitution des adresses absolues à partir des adresses transmises est plus complexe. Elle est décrite ci-dessous. Il reste ensuite à reconstituer les coefficients nuls en attribuant une valeur nulle aux coefficients qui sont situés à des adresses absolues pour lesquelles il n'y a pas eu décodage d'un coefficient transmis.

Les coefficients transmis doivent être décodés dans l'ordre des adresses absolues croissantes, c'est-à-dire dans le même ordre que pour le codage, mais les adresses absolues ne sont pas connues avant leur décodage.

Notamment, le premier coefficient à décoder peut être celui transmis en premier dans la classe n°1, ou celui transmis en premier dans la classe n°2, ou celui transmis en premier dans la classe n°3.

Le décodage des coefficients non nuls consiste à :
- stocker, classe par classe, au fur et à mesure qu'ils sont transmis, les coefficients et leurs adresses transmises, celles-ci ayant subi un décodage inverse du codage de Huffmann qu'elles ont subi avant la transmission ;
- reconstituer la valeur exacte de chaque coefficient transmis, en reconstituant le bit significatif de plus fort poids ;
- reconstituer l'adresse absolue de chaque mot transmis, à partir de son adresse transmise, en calculant une adresse relative hypothétique pour le premier coefficient non encore décodé dans chaque classe ; puis en calculant une adresse absolue hypothétique pour le premier coefficient non encore décodé dans chaque classe, égale à la somme de son adresse relative hypothétique et de l'adresse absolue du dernier coefficient décodé précédemment dans la classe du coefficlent considéré ; et en prenant pour adresse absolue définitive l'adresse absolue hypothétique ayant la valeur minimale parmi celles calculées pour toutes les classes. S'il y a plusieurs adresses absolues hypothétiques ayant une même valeur, le procédé consiste à sélectionner l'adresse absolue hypothétique correspondant à la classe ayant le plus petit numéro, parmi les classes contenant les coefficients ayant la même adresse absolue hypothétique.

Le coefficient correspondant à l'adresse ainsi sélectionnée est considéré comme définitivement décodé et l'adresse sélectionnée constitue son adresse absolue dans le bloc des coefficients décodés.

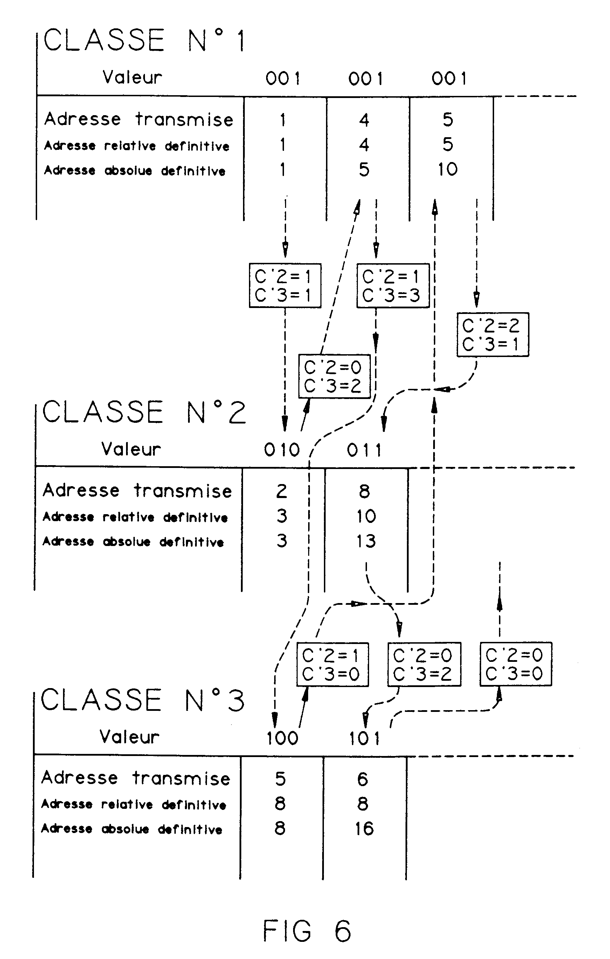

La figure 6 illustre la mise en oeuvre du procédé selon l'invention pour le décodage de l'exemple de blocs de coefficients de transformation cosinus donné sur la figure 1. Cette figure comporte trois tableaux correspondant respectivement aux coefficients transmis qui appartiennent respectivement aux classes n°1, n°2, et n°3. Ces tableaux indiquent, sous chaque coefficient reconstitué : la valeur de son adresse transmise, la valeur de son adresse relative définitive, et la valeur de son adresse absolue définitive. Cette figure ne représente donc pas les valeurs des adresses relatives hypothétiques et des adresses absolues hypothétiques qui sont utilisées en cours de décodage pour retrouver l'ordre originel des coefficients, qui est l'ordre des adresses absolues croissantes.

L'ordre de décodage des coefficients est représenté par des flèches en pointillés. Cette figure représente aussi l'évolution de deux valeurs : C′2 et C′3, correspondant respectivement à la classe n°2 et à la classe n°3 et jouant un rôle analogue à celui des valeurs C2 et C3 au cours du codage. La valeur C′2 est remise à zéro chaque fois qu'un coefficient transmis appartenant à la classe n°2 est décodé. Elle est incrémentée d'une unité chaque fois qu'un coefficient de la classe n°1 est décodé. La valeur C′3 est remise à zéro chaque fois qu'un coefficient transmis appartenant à la classe n°3 est décodé. Elle est incrémentée d'une unité chaque fois qu'un coefficient transmis appartenant à la classe n°1 ou à la classe n°2 est décodé. Naturellement les valeurs C′2 et C′3 sont initialisées à zéro au début du décodage d'un bloc.

Le décodage, dans cet exemple, consiste tout d'abord à calculer une adresse relative hypothétique puis une adresse absolue hypothétique respectivement pour le premier coefficient transmis appartenant à la classe n°1, pour le premier coefficient transmis appartenant à la classe n°2, et pour le premier coefficient transmis appartenant à la classe n°3. Le premier coefficient transmis appartenant à la classe n°1 a pour valeur : 001, et pour adresse transmise : 1. Puisqu'il n'y a pas de classe ayant un numéro inférieur au numéro 1, l'adresse relative hypothétique est égale à l'adresse transmise : 1. Puisque, par hypothèse, le coefficient considéré est le premier de la classe n°1, son adresse absolue hypothétique est égale à son adresse relative hypothétique : 1. Les variables C′2 et C′3 conservent leurs valeurs initiales nulles, pour le moment.

Dans la classe n°2, le premier coefficient transmis a pour valeur : 010, et pour adresse transmise : 2. Puisque la variable C′2 a été initialisée à zéro, l'adresse relative hypothétique est égale à l'adresse transmise : 2. Puisque, par hypothèse, le coefficient considéré est le premier coefficient transmis dans la classe n°2, son adresse absolue hypothétique est égale à son adresse relative hypothétique : 2. Pour le moment, la variable C′3 conserve sa valeur initiale nulle.

Dans la classe n°3, le premier coefficient transmis a pour valeur : 100, et pour adresse transmise : 5. Puisque la variable C′3 a été initialisée à zéro, l'adresse relative hypothétique est égale à l'adresse transmise : 5. Puisque, par hypothèse, le coefficient considéré est le premier coefficient transmis dans la classe n°3, l'adresse absolue hypothétique est égale à l'adresse relative hypothétique : 5.

Le décodage consiste alors à sélectionner la plus petite de ces trois adresses absolues hypothétiques. La plus petite est égale à 1 et correspond au coefficient de valeur : 001, appartenant à la classe n°1. Son adresse absolue hypothétique est alors considérée comme définitive. Ce coefficient est alors considéré comme complètement décodé, et le procédé consiste enfin à incrémenter d'une unité les variables C′2 et C′3. Elles sont alors chacune égale à 1.

Le procédé consiste ensuite à déterminer une adresse relative hypothétique puis une adresse absolue hypothétique respectivement pour le premier coefficient transmis qui n'a pas encore été décodé, dans la classe n°1, dans la classe n°2, et dans la classe n°3. Il est à remarquer que les adresses relatives hypothétiques et les adresses absolues hypothétiques du premier coefficient de la classe n°2 et du premier coefficient de la classe n°3 ne seront pas égales à celles calculées précédemment pour ces mêmes coefficients car les variables C′2 et C′3 ont été incrémentées entre-temps.

Dans la classe n°1, le premier coefficient transmis et qui n'a pas encore été décodé a pour valeur : 001 et a pour adresse transmise : 4. Puisque, dans la classe n°1, les adresses relatives sont égales aux adresses transmises, l'adresse relative hypothétique est égale à l'adresse transmise : 4. L'adresse absolue hypothétique est égale à 5, puisque le précédent coefficient dans la classe n°1 a pour adresse absolue définitive : 1. Dans la classe n°2, le premier coefficient transmis et qui n'a pas encore été décodé a pour valeur : 010, et pour adresse transmise : 2. Puisque la variable C′2 est égale à 1, l'adresse relative hypothétique est égale à 3. Puisqu'il n'y a pas eu de coefficient déjà décodé dans la classe n°2, l'adresse absolue hypothétique est égale à 3. Dans la classe n°3, le premier coefficient transmis et qui n'a pas encore été décodé a pour valeur : 100, et pour adresse transmise 5. Puisque la variable C′3 est égale à 1, l'adresse relative hypothétique est égale à 6. Puisqu'il n'y a pas eu précédemment de coefficient décodé dans la classe n°3, l'adresse absolue hypothétique est égale à l'adresse relative hypothétique : 6.

Le décodage consiste ensuite à déterminer qu'elle est l'adresse absolue hypothétique la plus petite parmi ces trois valeurs : 5, 3, 6. Le coefficient ayant l'adresse absolue hypothétique la plus petite est donc le coefficient de valeur : 010, appartenant à la classe n°2. Son adresse absolue définitive est donc égale à 3. Le procédé consiste enfin à réinitialiser à zéro la variable C′2 et à incrémenter d'une unité la variable C′3 qui prend donc la valeur 2.

Le procédé consiste ensuite à déterminer une adresse relative hypothétique puis une adresse absolue hypothétique pour le premier coefficient transmis qui n'a pas encore été décodé, respectivement dans la classe n°1, dans la classe n°2, et dans la classe n°3. Dans la classe n°1, le premier coefficient transmis et non encore décodé a pour valeur : 001, et pour adresse transmise : 4. Son adresse relative hypothétique est égale à 4 et son adresse absolue hypothétique est égale à 5 puisque le précédent coefficient dans la classe n°1 a pour adresse absolue définitive : 1. Dans la classe n°2, le premier coefficient transmis et non encore décodé a pour valeur : 011, et pour adresse transmise : 8. Son adresse relative hypothétique est égale à 8 puisque la variable C′2 est égale à 0, et son adresse absolue hypothétique est égale à 11, puisque le précédent coefficient dans la classe n°2 a pour adresse absolue définitive : 3. Dans la classe n°3, le premier coefficient transmis et non décodé a pour valeur : 100, et pour adresse transmise 5. Son adresse relative hypothétique est égale à 7, puisque la variable C′3 est égale à 2. Son adresse absolue hypothétique est égale à 7, puisqu'il n'y a pas eu de coefficient décodé précédemment dans la classe n°3.

Le procédé consiste alors à déterminer qu'elle est l'adresse absolue hypothétique la plus petite parmi : 5, 9, 7. L'adresse absolue qui est retenue est donc 5. Le coefficient décodé est donc le coefficient de valeur : 001, ayant l'adresse absolue définitive : 5, et qui appartient à la classe n°1. Les variables C′2 et C′3 sont alors incrémentées d'une unité et prennent les valeurs : 1 et 3 respectivement.

Le procédé consiste ensuite à déterminer une adresse relative hypothétique puis une adresse absolue hypothétique pour le premier coefficient transmis et non encore décodé, respectivement dans la classe n°1, la classe n°2, et la classe n°3. Dans la classe n°1, le premier coefficient non encore décodé a pour valeur : 001, et pour adresse transmise : 5. Son adresse relative hypothétique est égale à son adresse transmise : 5. Son adresse absolue hypothétique est égale à 10, puisque le précédent coefficient décodé dans la classe n°1 a pour adresse absolue définitive : 5. Dans la classe n°2, le premier coefficient non encore décodé a pour valeur : 011, et pour adresse transmise : 8. Son adresse relative hypothétique est égale à 9, puisque la variable C′2 est égale à 1. Son adresse absolue hypothétique est égale à 12, puisque le précédent coefficient décodé dans la classe n°2 a pour adresse absolue définitive : 3. Dans la classe n°3, le premier coefficient non encore décodé a pour valeur : 100, et pour adresse transmise : 5. Son adresse relative hypothétique est égale à 8, puisque la variable C′3 est égale à 3. Son adresse absolue hypothétique est égale à 8 puisqu'il n'y a pas de coefficient précédemment décodé dans la classe n°3. Le décodage consiste ensuite à sélectionner la plus petite adresse absolue hypothétique parmi : 10, 12, 8. Le coefficient qui est décodé est donc le coefficient de valeur : 100, d'adresse absolue définitive : 8, et appartenant à la classe n°3. La variable C′3 est alors réinitialisée à zéro. La variable C′2 garde sa valeur : 1.

Le procédé consiste ensuite à calculer une adresse relative hypothétique, puis une adresse absolue hypothétique pour le premier coefficient non encore décodé, respectivement dans la classe n°1, dans la classe n°2, et dans la classe n°3. Dans la classe n°1, le premier coefficient non encore décodé a pour valeur : 001, et pour adresse transmise : 5. Son adresse relative hypothétique est égale à son adresse transmise : 5. Son adresse absolue hypothétique est égale à 10, puisque le précédent coefficient décodé dans la classe n°1 a pour adresse absolue définitive : 5. Dans la classe n°2, le premier coefficient non encore décodé a pour valeur : 011, et pour adresse transmise : 8. Son adresse relative hypothétique est égale à 9, puisque la variable C′2 a la valeur 1. Son adresse absolue hypothétlque est alors égale à 12, puisque le précédent coefficient décodé a pour adresse absolue définitive : 3. Dans la classe n°3, le premier coefficient non encore décodé a pour valeur : 101, et pour adresse transmise : 6. Son adresse relative hypothétlque est égale à 6, puisque la variable C′3 est nulle. Son adresse absolue hypothétique est égale à 14, puisque le précédent coefficient dans la classe n°3 a pour adresse absolue définitive : 8.

Le procédé consiste alors à déterminer la plus petite adresse absolue hypothétique parmi : 10, 12, 14. Le coefficient qui est alors décodé est le coefficient de valeur : 001, ayant pour adresse absolue définitive : 10, et appartenant à la classe n°1. Les variables C′2 et C′3 sont incrémentées d'une unité et prennent respectivement pour valeurs : 2 et 1.

Le décodage des coefficients non nuls se poursuit de la même façon jusqu'à épuisement des coefficients à décoder dans toutes les classes.

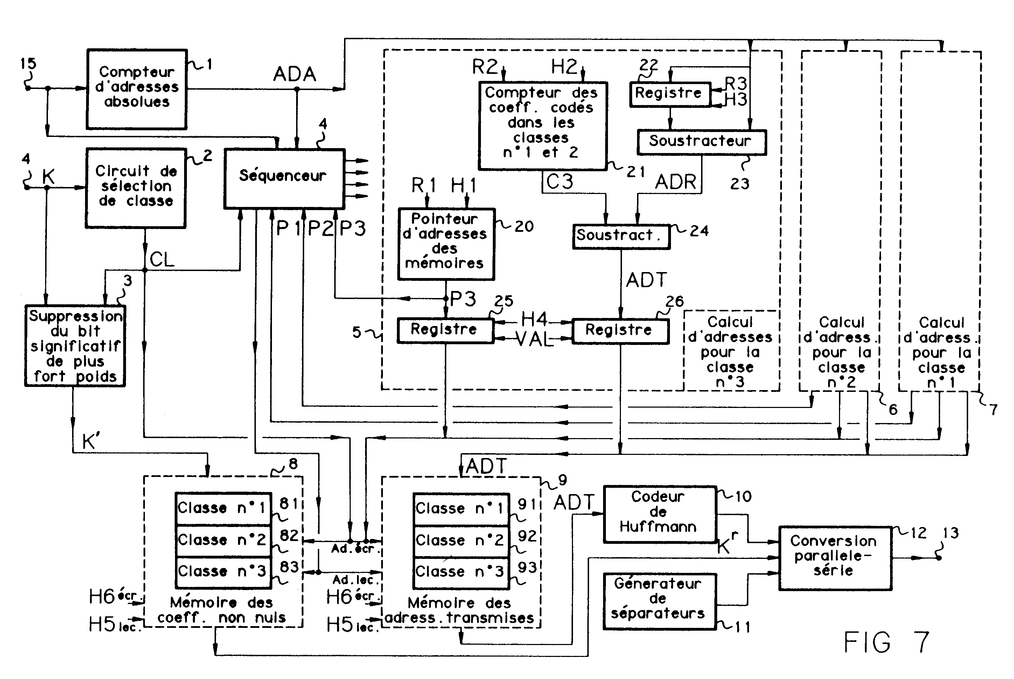

La figure 7 représente le schéma synoptique d'un exemple de réalisation du dispositif de codage pour la mise en oeuvre du procédé selon l'invention. Cet exemple comporte : deux bornes d'entrée, 14 et 15 recevant respectivement une suite de valeurs de coefficients de transformation cosinus, et une suite de signaux logiques de synchronisation ; un compteur d'adresses absolues, 1 ; un circuit 2 de sélection de classe ; un dispositif 3 de suppression du bit significatif de plus fort poids ; un séquenceur 4 ; trois dispositifs de calcul d'adresses, 5, 6, 7 ; une mémoire 8, dite mémoire des coefficients non nuls ; une mémoire 9, dite mémoire des adresses transmises ; un codeur de Huffmann, 10 ; un générateur de séparateurs, 11 ; un dispositif 12 de conversion parallèle-série ; et une borne de sortie 13 fournissant une suite de données binaires codées.

La borne d'entrée 14 est reliée à une entrée du circuit 2 et à une entrée du dispositif 3. Une sortie du circuit 2 est reliée à une entrée du dispositif 3, à une entrée du séquenceur 4, à deux bits d'une entrée d'adresses d'écriture commune à la mémoire 8 et à la mémoire 9. Ces deux bits sélectionnent une page, 81, ou 82, ou 83, dans la mémoire 8 et une page, 91, ou 92, ou 93, dans la mémoire 9. Les mémoires 8 et 9 comportent 3 pages correspondant respectivement à trois classes de coefficients. La borne d'entrée 15 est reliée à une entrée du compteur 1 et à une entrée du séquenceur 4. Une sortie du compteur 1 est reliée à une entrée du séquenceur 4 et à une entrée de chacun des dispositifs de calcul d'adresses, 5, 6, et 7. Des premières sorties des dispositifs 5, 6, 7 sont reliées respectivement à trois entrées du séquenceur 4. Des deuxièmes sorties des dispositifs 5, 6, 7 sont reliées à l'entrée d'adresse d'écriture commune à la mémoire 8 et à la mémoire 9. Des troisièmes sorties des dispositifs 5, 6, 7 sont reliées en parallèle à une entrée de données de la mémoire 9.

Une première sortie du séquenceur 4 est reliée à une entrée d'adresse de lecture commune à la mémoire 8 et à la mémoire 9. Une sortie du dispositif 3 est reliée à une entrée de données de la mémoire 8. Une sortie de la mémoire 8 est reliée à une entrée du dispositif 12. Une sortie de la mémoire 9 est reliée à une entrée du codeur de Huffmann, 10. Une sortie du codeur 10 et une sortie du générateur de séparateurs, 11, sont reliées respectivement à deux entrées du dispositif 12. Une sortie du dispositif 12 constitue la sortie du dispositif de codage et est reliée à la borne de sortie 13. Les mémoires 8 et 9 possèdent respectivement des entrées de commande d'écriture et des entrées de commande de lecture reliées, par des liaisons non représentées, à des sorties du séquenceur 4, et recevant des signaux d'horloge H6 et H5 respectivement.

Les dispositifs de calcul d'adresses, 5, 6, 7 sont destinés à calculer des adresses transmises, ADT, respectivement pour les coefficients des trois classes. Ils calculent en outre des adresses d'écritures, notées respectivement P3, P2, P1, pour inscrire les coefficients non nuls et leurs adresses transmises, respectivement dans les 3 pages des mémoires 8 et 9. Ces trois dispositifs sont réalisés d'une manière analogue. Par exemple, le dispositif 5 de calcul d'adresses pour la classe n°3 comporte : un pointeur d'adresses des mémoires, 20 ; un compteur 21 des coefficients codés dans les classes n°1 et n°2 ; deux soustracteurs 23 et 24 ; et trois registres : 22, 25, 26.

L'entrée du dispositif 5 est constituée par une entrée de données du registre 22 et une première entrée du soustracteur 23. Une seconde entrée du soustracteur 23 est reliée à une sortie du registre 22. Une sortie du soustracteur 23 est reliée à une première entrée du soustracteur 24. Une seconde entrée du soustracteur 24 est reliée à une sortie du compteur 21. Une sortie du soustracteur 24 est reliée à une entrée de données du registre 26. Le registre 22 possède une entrée de remise à zéro recevant un signal R3 fourni par le séquenceur 4 et une entrée d'horloge recevant un signal H3 fourni par le séquenceur 4. Le compteur 21 possède une entrée de remise à zéro recevant un signal R2 fourni par le séquenceur 4, et une entrée d'horloge recevant un signal d'horloge H2 fourni par une sortie du séquenceur 4.

Le pointeur d'adresses des mémoires, 20, possède une sortie qui constitue la première sortie du dispositif 5, et qui est reliée à une entrée de données du registre 25. Une sortie du registre 25 constitue la deuxième sortie du dispositif 5. Une sortie du registre 26 constitue la troisième sortie du dispositif 5. Les registres 25 et 26 possèdent chacun une entrée d'horloge recevant un signal d'horloge H4 fourni par une sortie du séquenceur 4, et possèdent chacun une entrée de validation recevant un signal de validation VAL fourni par une sortie du séquenceur 4. Le pointeur 20 possède deux entrées de commande recevant respectivement un signal de remise à zéro R1 et un signal d'horloge H1, fournis respectivement par deux sorties du séquenceur 4. Les liaisons entre les sorties du séquenceur 4 et les éléments constituant les dispositifs de calcul d'adresse 5, 6, 7 ne sont pas représentées sur la figure.

Le séquenceur 4 commande tous les éléments du dispositif de codage, pour réaliser la suite des étapes du procédé de codage. Le séquenceur 4 est synchronisé avec l'arrivée des coefficients de transformation cosinus à coder, grâce au signal de synchronisation appliqué à la borne d'entrée 15. Ce signal de synchronisation comporte une impulsion pour chaque coefficient à coder. Il est utilisé aussi par le compteur d'adresses absolues, 1, pour compter les coefficients à coder et produire ainsi une suite de valeurs d'adresses absolues ADA correspondant à l'ordre des coefficients appliqués à la borne d'entrée 14. Chaque valeur d'adresse absolue ADA est appliquée à l'entrée des dispositifs de calcul d'adresses, 5, 6, 7. L'un des dispositifs 5 à 7 est commandé par le séquenceur 4, selon la classe du coefficient à coder, pour déterminer une valeur d'adresse transmise, ADT, en fonction de ADA.

Chaque coefficient à coder, K, est appliqué au circuit 2 de sélection de classes, pour déterminer le nombre de bits significatif de ce coefficient et fournir un mot binaire CL traduisant ce nombre de bits significatifs. Les coefficients nuls sont attribués à une classe fictive n°0, la valeur de CL est alors nulle. Le mot binaire CL est appliqué au séquenceur 4 pour qu'il valide l'un des dispositifs de calcul d'adresses, 5, 6 ou 7, correspondant à la classe du coefficient à coder. Il est appliqué aussi à l'entrée d'adresses d'écriture des mémoires 8 et 9 pour valider une seule page de mémoire dans la mémoire 8 et une seule page de mémoire dans la mémoire 9. Enfin, il est appliqué à une entrée du dispositif 3 pour qu'il supprime le bit significatif de plus fort poids dans le mot binaire présentant le coefficient à coder K. Le mot binaire ainsi modifié, K′, est ensuite stocké dans la mémoire 8, dans la page sélectionnée par CL, à une adresse d'écriture fournie par le dispositif de calcul d'adresses qui est validé par le séquenceur 4. Son adresse transmise ADT est stockée simultanément dans la mémoire 9, à la même adresse.

Par exemple, si le coefficient à coder, K, comporte trois bits significatifs, le séquenceur 4 reçoit un mot binaire CL ayant la valeur 3 et il valide le dispositif de calcul d'adresse 6 qui correspond à la classe n°3. Le dispositif 6 fournit à l'entrée d'adresse d'écriture des mémoires 8 et 9 un complément d'adresse permettant l'écriture du mot binaire K′ dans la mémoire 8 et de l'adresse transmise ADT dans la mémoire 9. L'écriture est commandée par le signal d'horloge H6 fourni par le séquenceur 4. L'adresse d'écriture est déterminée par le pointeur 20 qui compte le nombre des cases de mémoire qui sont occupées dans la page de mémoire 83 correspondant à la classe n°3, dans la mémoire 8 et dans la mémoire 9. Le pointeur 20 est initialisé au début de chaque bloc de coefficients à coder, par le signal de remise à zéro R1. Il est incrémenté, lors de chaque écriture, par le signal d'horloge H1. La valeur P3 comptée par le pointeur 20 est fournie, d'une part, à une entrée du séquenceur 4 et, d'autre part, à une entrée du registre 25. Elle est stockée dans le registre 25 sous l'action du signal d'horloge H4. Le séquenceur 4 fournit le signal de validation VAL pour valider la sortie du registre 25 et fournir ainsi une adresse d'écriture à la mémoire 8 et à la mémoire 9.

Le registre 22 et le soustracteur 23 permettent de calculer une adresse relative ADR à partir d'une adresse absolue ADA. Le registre 22 est remis à zéro par le signal R3 au début de chaque bloc de coefficients à coder. Il stocke la valeur d'adresse absolue du précédent coefficient ayant été codé et appartenant à la classe n°3. Le séquenceur 4 lui fournit le signal H3 à la fin de l'opération de codage de chaque coefficient appartenant à la classe n°3, afin de renouveler la valeur qui est stockée dans le registre 22. Le compteur 21 est remis à zéro par le signal R2 au début de chaque bloc de coefficients à coder et à la fin du codage de chaque coefficient appartenant à la classe n°3. Il est incrémenté d'une unité par le signal H2 lors du codage d'un coefficient appartenant à la classe n°1 ou d'un coefficient appartenant à la classe n°2. Ainsi il fournit la valeur de la variable C3 qui compte les coefficients codés dans les classes n°1 et 2, depuis l'instant où a été codé le précédent coefficient appartenant à la classe n°3.

Le soustracteur 24 calcule la différence entre ADR et C3 pour fournir une adresse transmise ADT. Cette valeur est stockée dans le registre 26 sous l'action du signal d'horloge H4 puis elle est fournie à l'entrée de données de la mémoire 9 lorsque le registre 26 reçoit le signal de validation VAL. La valeur de l'adresse transmise est stockée dans la mémoire 9, en même temps que la valeur tronquée K′ du coefficient est stockée dans la mémoire 8, sous l'action d'un signal de commande d'écriture H6 qui lui est fournie par le séquenceur 4.

Les coefficients qui sont nuls appartiennent à la classe fictive n°0 qui ne donne lieu à aucune des opérations décrites précédemment. Rien n'est stocké dans les mémoires 8 et 9.

Le dispositif 7 de calcul d'adresses pour la classe n°1 ne comporte pas de compteur 21 ni de soustracteur 24 puisque la variable C1 correspondant à C2 et C3 a une valeur toujours nulle.

Lorsque la valeur de l'adresse absolue ADA atteint 64, cela signifie que tous les coefficients d'un bloc de 8x8 coefficients ont été traités. Les valeurs P1, P2, P3 sont alors respectivement égales aux nombres des coefficients dans les classes n°1, n°2, n°3. Le séquenceur 4 détecte que la valeur ADA est égale à 64. Il connaît alors le nombre P1, P2, P3, des coefficients dans chaque classe. Il commande alors une suite de lectures dans les mémoires 8 et 9 pour transmettre les coefficients non nuls, avec les adresses transmises correspondantes. Le séquenceur 4 commande une lecture dans la mémoire 8 et la mémoire 9, classe par classe, de la classe n°1 à la classe n°3. Le séquenceur 4 fournit une suite d'adresses de lecture allant de l'adresse 1 à l'adresse P1 dans la page correspondant à la classe n°1, puis allant de l'adresse 1 à l'adresse P2 dans la page correspondant à la classe n°2, puis allant de l'adresse 1 à l'adresse P3 dans la page correspondant à la classe n°3.

Chaque lecture est commandée par un signal d'horloge de lecture H5 que le séquenceur 4 fournit aux mémoires 8 et 9. La mémoire 8 fournit donc la valeur, K′, d'un coefficient amputé de son bit le plus significatif, au dispositif 12. La mémoire 9 fournit une valeur d'adresse transmise, ADT, au codeur de Huffmann 10. Le générateur de séparateurs, 11, fournit un motif séparateur inter-blocs au début du codage de chaque bloc. Puis il fournit un motif séparateur inter-classes avant la transmission des coefficients et des adresses de chaque classe. Le dispositif 12 est un dispositif classique de conversion parallèle-série permettant de transmettre toutes ces données sous la forme série, à un rythme constant. La réalisation du codeur 10, du générateur 11, et du dispositif 12 est classique et est à la portée de l'homme de l'Art.

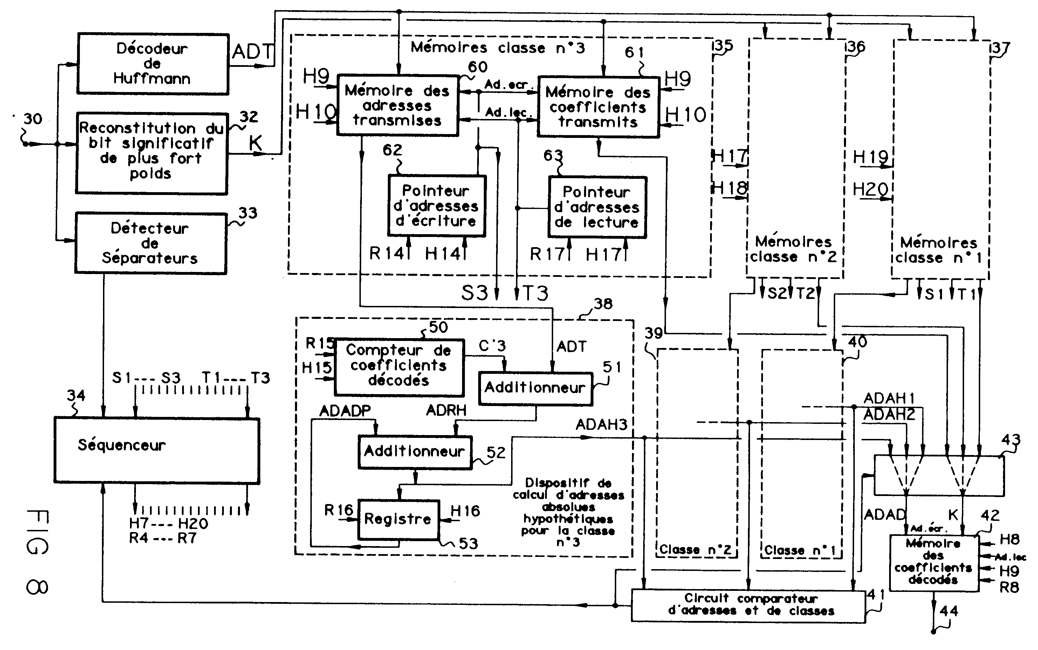

La figure 8 représente le schéma synoptique d'un exemple de réalisation d'un dispositif de décodage pour la mise en oeuvre du procédé selon l'invention. Cet exemple comporte : une borne d'entrée 30 recevant, sous forme série, une suite de coefficients de transformation cosinus codés par le procédé selon l'invention, les coefficients transmis étant accompagnés chacun d'une adresse transmise, et étant séparés par des séparateurs inter-blocs et des séparateurs inter-classes ; un décodeur de Huffmann 31 ; un dispositif 32 de reconstitution du bit significatif de plus plus fort poids ; un dispositif 33 détecteur de séparateurs ; un séquenceur 34 ; trois ensembles de mémoires, 35, 36, 37 correspondant respectivement aux classes n°1, n°2, n°3 ; trois dispositifs de calcul d'adresses absolues hypothétiques, 38, 39, 40 ; un circuit 41 comparateur d'adresses et de classes ; une mémoire 42 ; un multiplexeur 43, à six entrées et deux sorties ; et une borne de sortie 44 constituant la sortie du dispositif de décodage.

Les ensembles de mémoires 35, 36, 37 ont une structure semblable. Par exemple, l'ensemble de mémoires 35 de la classe n°3 comporte : une mémoire des adresses transmises, 60 ; une mémoire des coefficients transmis, 61 ; un pointeur d'adresses d'écriture, 62, ayant une sortie reliée à une entrée d'adresses d'écriture des mémoires 60 et 61 ; et un pointeur d'adresses de lecture 63, ayant une sortie reliée à une entrée d'adresses de lecture des mémoires 60 et 61. Les pointeurs 62 et 63 possèdent chacun une entrée de remise à zéro reliée à une sortie du séquenceur 34 par une liaison non représentée, et recevant des signaux de commande R14 et R17 respectivement. Ils possèdent aussi des entrées d'horloge reliées à des sorties du séquenceur 34 par des liaisons non représentées, et recevant respectivement des signaux d'horloge H14 et H17.

Les sorties des pointeurs 62 et 63 sont reliées respectivement à deux entrées du séquenceur 34, par des liaisons non représentées, pour lui fournir respectivement la valeur S3 de l'adresse d'écriture et la valeur T3 de l'adresse de lecture dans l'ensemble de mémoires 35. De même, l'ensemble de mémoires 36 est relié à deux entrées du séquenceur 34 pour lui fournir la valeur S2 de l'adresse d'écriture et la valeur T2 de l'adresse de lecture dans cet ensemble de mémoires 36 ; et l'ensemble de mémoires 37 est relié à deux entrées du séquenceur 34 pour lui fournir la valeur S1 de l'adresse d'écriture et la valeur T1 de l'adresse de lecture dans cet ensemble de mémoires 37.

Le détecteur de séparateurs, 33, possède une sortie reliée à une entrée du séquenceur 34 pour lui fournir un signal logique lorsqu'il détecte un séparateur inter-blocs, et un signal logique lorsqu'il détecte un séparateur inter-classes.

Le décodeur 31, le dispositif 32, et le détecteur 33 possèdent chacun une entrée reliée à la borne d'entrée 30 du dispositif de décodage. Le décodeur 31 possède une sortie reliée à une entrée de données de la mémoire 60 et à une entrée de données des mémoires homologues de la mémoire 60 pour la classe n°2 et pour la classe n°1. Le décodeur 31 fournit une valeur d'adresse transmise, ADT, pour chaque mot de code de Huffmann qu'il reçoit. Le dispositif 32 possède une sortie reliée à une entrée de données de la mémoire 61 et à une entrée de données des mémoires homologues de la mémoire 61 pour la classe n°2 et pour la classe n°1. Le dispositif 32 leur fournit la valeur K d'un coefficient où le bit significatif de poids le plus fort est reconstitué. L'écriture dans les mémoires 60 et 61 est réalisée simultanément sous la commande d'un signal d'horloge H9 fourni par une sortie du séquenceur 34. La lecture dans les mémoires 60 et 61 est réalisée simultanément sous la commande d'un signal d'horloge H10 fourni par une sortie du séquenceur 34.

Les ensembles de mémoires 36 et 37 sont commandés de manière similaire par des signaux d'horloge d'écriture H17 et H19, et des signaux d'horloge de lecture H18 et H20, respectivement pour les coefficients appartenant à la classe n°2 et pour ceux appartenant à la classe n°1.

Pendant la transmission des coefficients de la classe n°3, par exemple, la valeur ADT des adresses transmises et les valeurs K des coefficients reconstitués sont inscrites respectivement dans les mémoires 60 et 61 au fur et à mesure de leur transmission, à des adresses S3 fournies par le pointeur d'adresses d'écriture, 62, incrémenté par le signal d'horloge H14. Le signal H14 est fourni par le séquenceur 34 jusqu'à ce que le détecteur de séparateurs, 33, détecte la fin des données codées correspondant à la classe n°3. Puis le séquenceur 34 commande l'ensemble de mémoires 36 pour stocker les données codées correspondant à la classe n°2. Puis il commande l'ensemble de mémoires 37 pour stocker les données codées correspondant à la classe n°1. Enfin, le détecteur 33 détecte la fin des données codées correspondant à un bloc, et le décodage proprement dit commence alors.

Les dispositifs 38, 39, et 40, déterminent respectivement trois adresses absolues hypothétiques ADAH3, ADAH2, ADAH1, respectivement pour le premier coefficient transmis dans chacune des classes. Pour décoder un coefficient, le séquenceur 34 commande l'incrémentation du pointeur d'adresses de lecture 63 et de ses homologues, puis commande une lecture dans les mémoires 60 et 61, et dans les mémoires homologues. A chaque instant, le pointeur 63 indique l'adresse T3 où est stocké le premier coefficient non encore décodé dans la classe n°3. Le pointeur 63 n'étant pas incrémenté lorsque la valeur d'adresse absolue hypothétique ADAH3 n'est pas validée comme adresse absolue définitive, il continue alors à fournir la même valeur d'adresse de lecture T3, désignant le même coefficient non encore décodé, pour le décodage d'un prochain coefficient.

Le séquenceur 34 arrête d'incrémenter le pointeur 63, respectivement les pointeurs homologues, lorsque la valeur d'adresse de lecture T3 a atteint la dernière valeur de l'adresse d'écriture S3 ; respectivement lorsque la valeur d'adresse de lecture T2 a atteint la dernière valeur de l'adresse d'écriture S2 ; respectivement lorsque la valeur d'adresse de lecture T1 a atteint la dernière valeur de l'adresse d'écriture S1. Lorsque tous les coefficients stockés ont été effectivement décodés, les ensembles de mémoires 35 à 37 sont disponibles pour le décodage d'un prochain bloc de coefficients.

La mémoire 60 possède une sortie reliée à une entrée du dispositif 38 de calcul d'adresses absolues hypothétiques, pour la classe n°3. De même les mémoires homologues pour la classe n°2 et pour la classe n°1 possèdent chacune une sortie reliée à une entrée des dispositifs 39 et 40 respectivement. Une sortie de la mémoire 61 est reliée à une entrée du multiplexeur 43. De même une sortie d'une mémoire homologue pour la classe n°2 et une sortie d'une mémoire homologue pour la classe n°1 sont reliées respectivement à deux autres entrées du multiplexeur 43. Le multiplexeur 43 sélectionne une valeur de coefficient K fournie par l'une de ces trois sorties et la transmet à sa première sortie qui est reliée à une entrée de données de la mémoire 42.

Le dispositif 38 de calcul d'adresses absolues hypothétiques pour la classe n°3, comporte : un compteur de coefficients décodées, 50 ; deux additionneurs, 51 et 52 ; et un registre 53. Une première entrée de l'additionneur 51 est reliée à l'entrée du dispositif 38. Une seconde entrée de l'additionneur 51 est reliée à une sortie du compteur 50. Une première entrée et une seconde entrée de l'additionneur 52 sont reliées respectivement à une sortie de l'additionneur 51 et à une sortie du registre 53. Une sortie de l'additionneur 52 est reliée à la sortie du dispositif 38 et à une entrée de données du registre 53. Le compteur 50 possède une entrée de remise à zéro recevant un signal R15 fourni par le séquenceur 34 au début du décodage de chaque bloc et chaque fois qu'un coefficient de la classe n°3 a été décodé. Une autre entrée du compteur 50 reçoit un signal d'horloge H15 fourni par le séquenceur 34 pour incrémenter son contenu d'une unité chaque fois qu'un coefficient est décodé dans l'une des classes n°1 et n°2.

Le compteur 53 fournit donc la valeur de la variable C′3 à l'additionneur 51. Ce dernier reçoit une valeur d'adresse transmise ADT. L'additionneur 51 calcule alors une valeur d'adresse relative hypothétique ADRH. Cette dernière est additionnée à une valeur d'adresse absolue ADADP qui est l'adresse absolue définitive du précédent coefficient décodé dans la classe n°3. Cette adresse est fournie par la sortie du registre 53 qui a pour fonction de stocker la dernière valeur d'adresse absolue définitive calculée pour un coefficient de la classe n°3. Le registre 53 comporte une entrée de remise à zéro recevant un signal R16 fourni par le séquenceur 34 au début du décodage de chaque bloc, et une entrée d'horloge recevant un signal d'horloge H16 fourni par une sortie du séquenceur 34 lorsque l'adresse absolue hypothétique ADAH3 fournie par le dispositif 38 est validée comme adresse absolue définitive.

Une sortie du dispositif 38, une sortie homologue du dispositif 39, et une sortie homologue du dispositif 40 sont reliées respectivement à trois autres entrées du multiplexeur 43. Le multiplexeur 43 transmet une valeur d'adresse absolue hypothétique, fournie à l'une de ses trois entrées, vers sa seconde sortie qui est reliée à une entrée d'adresses d'écriture de la mémoire 42. Ces trois sorties des dispositifs 38, 39, 40 sont reliées aussi à trois entrées du circuit comparateur 41. Une sortie du circuit comparateur 41 est reliée à une entrée de commande du multiplexeur 43 et à une entrée du séquenceur 34. Une sortie de la mémoire 42 est reliée à la borne de sortie 44 qui constitue la sortie du dispositif de décodage. La mémoire 42 possède en outre : une entrée d'adresses de lecture, une entrée d'horloge de lecture, une entrée d'horloge d'écriture, et une entrée de remise à zéro, reliées respectivement à quatre sorties du séquenceur 34 par des liaisons non représentées.

Les dispositifs 38, 39, et 40 fournissent respectivement trois valeurs d'adresses absolues hypothétiques ADAH3, ADAH2, et ADAH1, au circuit comparateur 41. Ces valeurs sont comparées par le circuit 41 qui fournit sur sa sortie un mot binaire V traduisant le numéro de la classe pour laquelle l'adresse absolue hypothétique est la plus petite. En cas d'égalité entre plusieurs adresses hypothétiques, le comparateur 41 compare en outre les numéros des classes correspondants aux adresses absolues hypothétiques qui sont égales. L'adresse sélectionnée ainsi est considéré comme valide pour constituer une adresse absolue définitive. Ce mot binaire V commande le multiplexeur 43 pour qu'il transmette l'adresse absolue hypothétique et la valeur du coefficient correspondant à la classe pour laquelle l'adresse est validée. Le multiplexeur 43 fournit alors la valeur K d'un coefficient décodé et une valeur d'adresse absolue définitive ADAD, à la mémoire 42. Le séquenceur 34 fournit à l'entrée d'horloge d'écriture de la mémoire 42 un signal H11 après la validation de l'adresse ADAD, pour stocker le coefficient K à l'adresse ADAD.

La mémoire 42 possède une entrée de remise à zéro recevant un signal de remise à zéro R8 fourni par le séquenceur 34 au début du codage de chaque bloc, afin de remettre à zéro toutes les cases mémoires de la mémoire 42. Les coefficients nuls ne sont pas transmis ni décodés, par contre ils sont reconstitués dans la mémoire 42 car les cases mémoires correspondantes contiennent une valeur nulle.

A la fin du décodage d'un bloc, le séquenceur 34 fournit à l'entrée d'adresses de lecture de la mémoire 42 une suite d'adresses de lecture consécutives, et il fournit, à son entrée d'horloge de lecture, une suite de signaux d'horloge H12 pour restituer, sur la borne de sortie 44, la suite des coefficients de transformation cosinus d'un bloc, dans l'ordre où ils avait été fournis à l'entrée du dispositif de codage.

Les applications du procédé de codage selon l'invention ne se limitent pas au domaine de la compression d'image. Ce procédé est applicable à toute sorte de blocs de mots d'informations, en particulier lorsque leurs probabilités d'apparition n'ont pas une répartition statistique permettant d'utiliser avantageusement un codage de Huffmann.

## Revendications

1. Procédé de codage et de décodage d'informations, par blocs, chaque bloc étant constitué d'un nombre fixé de mots d'informations comportant chacun n bits, au maximum ; et la position des mots dans chaque bloc étant repérée par une suite d'adresses, dites absolues, ayant des valeurs consécutives,
le codage consistant à :
- classer les mots dans n classes n°1 pour i=1 à n, la classe n°i regroupant tous les mots ayant i bits significatifs ;
- transmettre, classe par classe, et dans l'ordre des adresses absolues croissantes, les mots qui ont une valeur non nulle, en omettant le bit significatif de plus fort poids, et chaque mot étant accompagné d'une adresse dite adresse transmise, codée par un code à longueur variable ; le décodage consistant à :
- stocker, classe par classe, les mots et leurs adresses transmises ;
- reconstituer le bit significatif de plus fort poids, de chaque mot ;
- reconstituer l'adresse absolue de chaque mot transmis, à partir de son adresse transmise ;
- reconstituer un bloc de mots d'informations, à partir des mots dont la valeur et l'adresse absolue ont été reconstituées, en insérant des mots de valeur nulle aux adresses absolues pour lesquelles aucun mot n'a été transmis ;
caractérisé en ce que pour déterminer chaque adresse transmise, le codage consiste à calculer une adresse dite relative, en soustrayant, à l'adresse absolue du mot à coder, l'adresse absolue du dernier mot ayant été codé précédemment dans la même classe ; puis à calculer une adresse transmise, en soustrayant, à l'adresse relative, le nombre (Cᵢ) des mots qui ont été codés entre le mot à coder et le dernier mot précédemment codé dans la même classe, et qui appartiennent à une classe ayant un numéro inférieur à celui de la classe du mot à coder ;
et en ce que pour reconstituer l'adresse absolue de chaque mot transmis, à partir de son adresse transmise, le décodage consiste à :
- calculer une adresse relative hypothétique pour le premier mot non encore décodé dans chaque classe n°i, pour i=1 à n, en additionnant à l'adresse transmise avec ce mot, le nombre (C′ᵢ) des mots qui ont été décodés entre le mot à décoder et le dernier mot précédemment décodé dans la même classe, et qui appartiennent à une classe ayant un numéro inférieur à celui de la classe du mot à décoder ;
- puis calculer une adresse absolue hypothétique, pour le premier mot non encore décodé dans chaque classe, en additionnant son adresse relative hypothétique et l'adresse absolue du dernier mot décodé précédemment dans la même classe du mot ;
- sélectionner l'adresse absolue hypothétique ayant la valeur minimale, en sélectionnant éventuellement l'adresse absolue hypothétique correspondant à la classe de numéro minimal, s'il y a plusieurs mots ayant la même adresse absolue hypothétique minimale, l'adresse sélectionnée constituant l'adresse absolue décodée du mot correspondant.

2. Procédé selon la revendication 1, caractérisé en ce que, pour transmettre, classe par classe, les mots d'informations et leurs adresses, il consiste à séparer les mots d'informations et les adresses correspondant à deux classes distinctes, en transmettant pour chaque classe, un mot binaire séparateur inter-classes, inimitable par toute concaténation licite des mots d'informations et des adresses.

3. Procédé selon la revendication 1, caractérisé en ce que, pour transmettre, classe par classe, les mots d'informations, il consiste à distinguer les mots d'informations et les adresses correspondant à deux classes distinctes, en transmettant, pour chaque classe, un mot binaire indiquant le nombre de coefficients non nuls à transmettre.

4. Dispositif de codage d'informations par blocs, pour la mise en oeuvre du procédé selon la revendication 1, chaque bloc étant constitué d'une suite de mots d'informations comportant chacun n bits, au maximum ; caractérisé en ce qu'il comporte :
- des moyens (2) pour déterminer le nombre de bits significatifs de chaque mot ;
- n premières mémoires n°i (81, 82, 83) où i=1 à n, pour stocker dans chaque mémoire n°i (81, 82, 83) les mots ayant une valeur non nulle et comportant i bits significatifs, ces mots étant stockés en supprimant le bit le plus significatif ;
- des moyens (1) pour calculer une adresse absolue pour chaque mot, en fonction de la position du mot dans son bloc ;
- des moyens (22, 23) pour calculer une adresse relative, pour chaque mot ayant une valeur non nulle, en soustrayant à son adresse absolue, l'adresse absolue du mot ayant été stocké immédiatement précédemment dans la même première mémoire n°i (81, 82, 83) ;
- des moyens (21) pour compter le nombre (Cᵢ) de mots ayant été stockés dans chacune des premières mémoires n°1 à i-1 (81, 82, 83), depuis le dernier stockage d'un mot d'informations dans la première mémoire n°i (81, 82, 83) ;
- des moyens (24) pour calculer une adresse dite transmise, pour chaque mot ayant une valeur non nulle, en soustrayant à son adresse relative, le nombre (Cᵢ) de mots ayant été stockés dans les premières mémoires n°1 à i-1 (81, 82, 83), depuis le dernier stockage d'un mot d'informations dans la première mémoire n°i (81, 82, 83) ;
- n secondes mémoires n°i (91, 92, 93), où i=1 à n; pour stocker les adresses relatives des mots qui sont stockés respectivement dans les premières mémoires n°1 à n (81, 82, 83) ;
- des moyens (4) pour lire successivement chaque mot et son adresse relative, respectivement dans les premières et les secondes mémoires (81, 82, 83 ; 91, 92, 93), successivement dans l'ordre n°1 à n ;
- des moyens (10 à 12) pour transmettre les mots et les adresses relatives, en codant les adresses relatives selon un code à longueur variable.

5. Dispositif de décodage d'informations par blocs, pour la mise en oeuvre du procédé selon la revendication 1, recevant une suite de mots d'informations dans lesquels le bit significatif de plus fort poids a été supprimé ; qui sont accompagnés chacun d'une adresse dite transmise, codée selon un code à longueur variable ; et qui sont transmis en regroupant tous les mots ayant un même nombre de bits significatifs ;
caractérisé en ce qu'il comporte :
- des moyens (31) pour recevoir les adresses relatives codées et pour les décoder selon le code à longueur variable ;
- des moyens (32) pour reconstituer le bit significatif de plus fort poids dans chaque mot transmis ;
- n premières et n secondes mémoires (60, 61) pour stocker respectivement les mots transmis et leurs adresses relatives, n étant le nombre maximal de bits significatifs dans les mots ; chaque première mémoire n°i (60) stockant les mots ayant i bits significatifs, et chaque seconde mémoire n°1 (61) stockant les adresses relatives correspondant à ces mots, pour i=1 à n ;
- des moyens (38 à 40) associés à chaque première mémoire n°i (60), où i=1 à n, pour :
-- compter le nombre de mots (C′ᵢ) ayant été lus dans les premières mémoires n°1 à i-1 (60), depuis la dernière lecture d'un mot dans la première mémoire n°i (60) ;
-- calculer une adresse, dite relative hypothétique, pour le premier mot non encore lu dans chaque première mémoire n°i pour i=1 à n (60), en additionnant à son adresse transmise, le nombre de mots ayant été lus dans les premières mémoires n°1 à i-1 (60), depuis la dernière lecture d'un mot dans la première mémoire n°i (60) ;
-- calculer une adresse absolue hypothétique pour le premier mot non encore lu dans chaque première mémoire n°i (60), où i=1 à n, en additionnant son adresse relative hypothétique et l'adresse absolue du dernier mot lu précédemment dans la première mémoire n°i (60) ;
- des moyens (41, 42) pour sélectionner une adresse absolue, dite définitive, qui est l'adresse absolue hypothétique ayant la valeur minimale, parmi les n adresses, fournies par les moyens précédents (38, 40), en sélectionnant éventuellement celle correspondant à la première mémoire (60) ayant le plus petit numéro, s'il y a plusieurs mots ayant une adresse absolue hypothétique égale à la valeur minimale ;
- des moyens (34) pour lire dans la première mémoire (60) correspondant à l'adresse absolue définitive, le mot correspondant à cette adresse absolue définitive et pour le stocker dans une troisième mémoire (42), dans l'ordre des adresses absolues croissantes, pour reconstituer un bloc de mots.

## Claims

1. Method for coding and decoding blocks of data, each block consisting of a fixed number of data words each containing at most n bits; and the position of the words in each block being labelled by a sequence of so-called absolute addresses, having consecutive values,
the coding consisting in:
- classifying the words into n classes No. i for i=1 to n, class No. i grouping together all the words having i significant bits;
- forwarding, class by class, and in the order of ascending absolute addresses, the words which have a non-zero value, while omitting the most significant bit, and each word being accompanied by an address termed the forwarded address, coded by a variable-length code;
the decoding consisting in:
- storing, class by class, the words and their forwarded addresses;
- reconstructing the most significant bit of each word;
- reconstructing the absolute address of each forwarded word from its forwarded address;
- reconstructing a block of data words from words whose value and absolute address have been reconstructed, while inserting words of zero value at the absolute addresses for which no word has been forwarded;
characterised in that, in order to determine each forwarded address, the coding consists in calculating a so-called relative address, by subtracting, from the absolute address of the word to be coded, the absolute address of the last word having been coded previously in the same class; in then calculating a forwarded address, by subtracting, from the relative address, the number (Cᵢ) of words which have been coded between the word to be coded and the last word previously coded in the same class, and which belong to a class having an index below that of the class of the word to be coded;
and in that, in order to reconstruct the absolute address of each forwarded word from its forwarded address, the decoding consists in:
- calculating a hypothetical relative address for the first as yet undecoded word in each class No. i, for i=1 to n, by adding to the address forwarded with this word, the number (C'ᵢ) of words which have been decoded between the word to be decoded and the last word previously decoded in the same class, and which belong to a class having an index below that of the class of the word to be decoded;
- then calculating a hypothetical absolute address, for the first as yet undecoded word in each class, by adding its hypothetical relative address and the absolute address of the last word previously decoded in the same class of the word;
- selecting the hypothetical absolute address having the minimum value, by optionally selecting the hypothetical absolute address corresponding to the class of minimum index, if there are several words having the same minimum hypothetical absolute address, the selected address constituting the decoded absolute address of the corresponding word.

2. Method according to Claim 1, characterised in that, in order to forward, class by class, the data words and their addresses, it consists in separating the data words and the addresses corresponding to two distinct classes, by forwarding for each class an inter-class separator binary word which cannot be imitated by any licit concatenation of the data words and addresses.

3. Method according to Claim 1, characterised in that, in order to forward, class by class, the data words, it consists in picking out the data words and the addresses corresponding to two distinct classes, by forwarding, for each class, a binary word indicating the number of non-zero coefficients to be forwarded.

4. Apparatus for coding blocks of data, for carrying out the method according to Claim 1, each block consisting of a sequence of data words each containing at most n bits; characterised in that it includes:
- means (2) for determining the number of significant bits of each word;
- n first memories No. i (81, 82, 83) where i=1 to n, for storing in each memory No. i (81, 82, 83) the words having a non-zero value and containing i significant bits, these words being stored by deleting the most significant bit;
- means (1) for calculating an absolute address for each word as a function of the position of the word in its block;
- means (22, 23) for calculating a relative address for each word having a non-zero value, by subtracting from its absolute address the absolute address of the word having been stored immediately previously in the same first memory No. i (81, 82, 83);
- means (21) for counting the number (Cᵢ) of words having been stored in each of the first memories No. i to i-1 (81, 82, 83) since the last storage of a data word in the first memory No. i (81, 82, 83);
- means (24) for calculating a so-called forwarded address for each word having a non-zero value, by subtracting from its relative address the number (Cᵢ) of words having been stored in the first memories No. 1 to i-1 (81, 82, 83), since the last storage of a data word in the first memory No. i (81, 82, 83);
- n second memories No. i (91, 92, 93) where i=1 to n; for storing the relative addresses of the words which are stored respectively in the first memories No. 1 to n (81, 82, 83);
- means (4) for successively reading each word and its relative address, respectively from the first and the second memories (81, 82, 83; 91, 92, 93), successively in the order No. 1 to n;
- means (10 to 12) for forwarding the words and the relative addresses, by coding the relative addresses according to a variable-length code.

5. Apparatus for decoding blocks of data for carrying out the method according to Claim 1, receiving a sequence of data words in which the most significant bit has been deleted; which are each accompanied by a so-called forwarded address coded according to a variable-length code; and which are forwarded by grouping together all the words having the same number of significant bits;
characterised in that it includes:
- means (31) for receiving the coded relative addresses and for decoding them according to the variable-length code;
- means (32) for reconstructing the most significant bit in each forwarded word;
- n first and n second memories (60, 61) for storing respectively the forwarded words and their relative addresses, n being the maximum number of significant bits in the words; each first memory No. i (60) storing the words having i significant bits, and each second memory No. i (61) storing the relative addresses corresponding to these words, for i=1 to n;
- means (38 to 40) associated with each first memory No. i (60), where i=1 to n, for:
-- counting the number of words (C'ᵢ) having been read from the first memories No. i to i-1 (60), since the last reading of a word from the first memory No. i (60);
-- calculating a so-called hypothetical relative address for the first as yet unread word in each first memory No. i for i=1 to n (60), by adding to its forwarding address the number of words having been read from the first memories No. 1 to i-1 (60), since the last reading of a word from the first memory No. i (60);
-- calculating a hypothetical absolute address for the first as yet unread word in each first memory No. i (60), where i=1 to n, by adding its hypothetical relative address and the absolute address of the last word previously read from the first memory No. i (60);
- means (41, 42) for selecting a so-called definitive absolute address which is the hypothetical absolute address having the minimum value, out of the n addresses, delivered by the previous means (38, 40), by optionally selecting the one corresponding to the first memory (60) having the smallest index, if there are several words having a hypothetical absolute address equal to the minimum value;
- means (34) for reading, from the first memory (60) corresponding to the definitive absolute address, the word corresponding to this definitive absolute address and for storing it in a third memory (42), in the order of ascending absolute addresses, in order to reconstruct a block of words.

## Patentansprüche

1. Verfahren zur blockweisen Codierung und Decodierung von Informationen, wobei jeder Block von einer festen Anzahl von Informationswörtern mit jeweils höchstens n Bits gebildet ist; und wobei die Position der Wörter in jedem Block durch eine Folge von sogenannten Absolutadressen mit aufeinanderfolgenden Werten gekennzeichnet ist,
wobei die Codierung darin besteht, daß
- die Wörter in n Klassen Nr. i für i = 1 bis n klassifiziert werden, wobei in der Klasse Nr. i sämtliche Wörter mit i Wertigkeitsbits zusammengefaßt sind;
- die Wörter, die einen von Null verschiedenen Wert besitzen, klassenweise und in der Reihenfolge aufsteigender Absolutadressen übertragen werden, wobei das höchstwertige Bit weggelassen wird und wobei jedes Wort von einer sogenannten übertragenen Adressen begleitet wird, die durch einen Code mit variabler Länge codiert ist;
wobei die Decodierung darin besteht, daß:
- die Wörter und ihre übertragenen Adressen klassenweise gespeichert werden;
- das höchstwertige Bit eines jeden Wortes wiederhergestellt wird;
- die Absolutadresse eines jeden übertragenen Wortes anhand der übertragenen Adresse wiederhergestellt wird;
- ein Block von Informationswörtern anhand der Wörter, deren Wert und deren Absolutadresse wiederhergestellt worden sind, wiederhergestellt wird, indem Wörter mit Wert Null an diejenigen Absolutadressen eingefügt werden, für die kein Wort übertragen worden ist;
dadurch gekennzeichnet, daß für die Bestimmung einer jeden übertragenen Adresse die Codierung darin besteht, daß eine sogenannte Relativadresse berechnet wird, indem von der Absolutadresse des zu codierenden Wortes die Absolutadresse des letzten Wortes derselben Klasse, das vorher codiert worden ist, subtrahiert wird; und daß dann eine übertragene Adresse berechnet wird, indem von der Relativadresse die Anzahl (Cᵢ) derjenigen Wörter subtrahiert wird, die zwischen dem zu codierenden Wort und dem letzten zuvor codierten Wort derselben Klasse codiert worden sind und die einer Klasse zugehören, deren Nummer kleiner als diejenige der Klasse des zu codierenden Wortes ist;
und daß für die Wiederherstellung der Absolutadresse eines jeden übertragenen Wortes anhand ihrer übertragenen Adresse die Decodierung darin besteht, daß:
- für das erste noch nicht decodierte Wort in jeder Klasse Nr. i für i = 1 bis n eine hypothetische Relativadresse berechnet wird, indem zu der mit diesem Wort übertragenen Adresse die Anzahl (C'ᵢ) derjenigen Wörter addiert wird, die zwischen dem zu decodierenden Wort und dem letzten zuvor decodierten Wort derselben Klasse decodiert worden sind und die einer Klasse zugehören, deren Nummer kleiner als diejenige der Klasse des zu decodierenden Wortes ist;
- anschließend für das erste noch nicht decodierte Wort in jeder Klasse eine hypothetische Absolutadresse berechnet wird, indem deren hypothetische Relativadresse und die Absolutadresse des letzten vorher decodierten Wortes in derselben Klasse des Wortes addiert werden;
- die hypothetische Absolutadresse mit dem minimalen Wert gewählt wird, indem eventuell die hypothetische Absolutadresse gewählt wird, die der Klasse mit der kleinsten Nummer entspricht, falls mehrere Wörter mit derselben minimalen hypothetische Absolutadresse vorhanden sind, wobei die gewählte Adresse die decodierte Absolutadresse des entsprechenden Wortes bildet.

2. Verfahren gemäß Anspruch 1, dadurch gekennzeichnet, daß es für die klassenweise Übertragung der Informationswörter und ihrer Adressen darin besteht, daß die Informationswörter und ihre entsprechenden Adressen in zwei verschiedene Klassen getrennt werden, indem für jede Klasse ein Klassentrennungs-Binärwort übertragen wird, daß durch keine zulässige Verkettung von Informationswörtern und Adressen nachgebildet werden kann.

3. Verfahren gemäß Anspruch 1, dadurch gekennzeichnet, daß es für die klassenweise Übertragung der Informationswörter darin besteht, daß die Informationswörter und die entsprechenden Adressen in zwei verschiedene Klassen unterteilt werden, indem für jede Klasse ein Binärwort übertragen wird, das die Anzahl der von Null verschiedenen zu übertragenden Koeffizienten angibt.

4. Einrichtung zur blockweisen Codierung von Informationen für die Ausführung des Verfahrens gemäß Anspruch 1, wobei jeder Block durch eine Folge von Informationswörtern mit jeweils höchstens n Bits gebildet ist; dadurch gekennzeichnet, daß sie umfaßt:
- Mittel (2) zur Bestimmung der Anzahl der Wertigkeitsbits eines jeden Wortes;
- n erste Speicher Nr. i (81, 82, 83), mit i = 1 bis n, um in jedem Speicher Nr. i (81, 82, 83) die Wörter zu speichern, die einen von Null verschiedenen Wert besitzen und i Wertigkeitsbits enthalten, wobei diese Wörter gespeichert werden, indem das höchstwertige Bit weggelassen wird;
- Mittel (1) zur Berechnung einer Absolutadresse für jedes Wort in Abhängigkeit von der Position des Wortes in seinem Block;
- Mittel (22, 23,) zur Berechnung einer Relativadresse für jedes Wort, das einen von Null verschiedenen Wert besitzt, indem von seiner Absolutadresse die Absolutadresse des unmittelbar vorher im selben Speicher Nr. i (81, 82, 83) gespeicherten Wortes subtrahiert wird;
- Mittel (21) zum Zählen der Anzahl (Cᵢ) der Wörter, die in jedem der ersten Speicher Nr. 1 bis i - 1 (81, 82, 83) seit der letzten Speicherung eines Informationswortes im ersten Speicher Nr. i (81, 82, 83) gespeichert worden sind;
- Mittel (24) zur Berechnung einer sogenannten übertragenen Adresse für jedes Wort mit einem von Null verschiedenen Wert, indem von seiner Relativadresse die Anzahl (Cᵢ) derjenigen Wörter subtrahiert wird, die in den ersten Speichern Nr. 1 bis i - 1 (81, 82, 83) seit der letzten Speicherung eines Informationswortes im ersten Speicher Nr. i (81, 82, 83) gespeichert worden sind;
- n zweite Speicher Nr. i (91, 92, 93), mit i = 1 bis n; um die Relativadressen der Wörter, die entsprechend jeweils in den ersten Speichern Nr. 1 bis n (81, 82, 83) gespeichert worden sind;
- Mittel (4) zum aufeinanderfolgenden Lesen eines jeden Wortes und seiner Relativadresse in den ersten bzw. zweiten Speichern (81, 82, 83; 91, 92, 93) nacheinander in der Reihenfolge Nr. 1 bis n;
- Mittel (10 bis 12) zur Übertragung der Wörter und der Relativadressen, indem die Relativadressen gemäß einem Code mit variabler Länge codiert werden.

5. Einrichtung zur blockweisen Decodierung von Informationen für die Ausführung des Verfahrens gemäß Anspruch 1, indem eine Folge von Informationswörtern empfangen wird, in denen das höchstwertige Bit weggelassen worden ist; die jeweils von einer sogenannten übertragenen Adresse begleitet werden, welche gemäß einem Code mit variabler Länge codiert ist; und die übertragen werden, indem sämtliche Wörter mit derselben Anzahl von Wertigkeitsbits zusammengefaßt werden;
dadurch gekennzeichnet, daß sie umfaßt:
- Mittel (31) zum Empfangen der codierten Relativadressen und zum Decodieren derselben gemäß dem Code mit variabler Länge;
- Mittel (32) zur Wiederherstellung des höchstwertigen Bits in jedem übertragenen Wort;
- n erste und n zweite Speicher (60, 61) zum Speichern der übertragenen Wörter bzw. ihrer Relativadressen, wobei n die maximale Anzahl der Wertigkeitsbits in den Wörtern ist; wobei in jedem ersten Speicher Nr. i (60) die Wörter mit i Wertigkeitsbits gespeichert werden und wobei in jedem zweiten Speicher Nr. i (61) die diesen Wörtern entsprechenden Relativadressen für i = 1 bis n gespeichert werden;
- Mittel (38 bis 40), die jedem ersten Speicher Nr. i (60), mit i = 1 bis n, zugeordnet sind, um:
-- die Anzahl derjenigen Wörter (C'ᵢ) zu zählen, die in den ersten Speichern 1 bis i - 1 (60) seit dem letzten Lesen eines Wortes im ersten Speicher Nr. i (60) gelesen worden sind;
-- eine sogenannte hypothetische Relativadresse für das erste noch nicht gelesene Wort in jedem ersten Speicher Nr. i für i = 1 bis n (60) zu berechnen, indem zu dessen übertragener Adresse die Anzahl derjenigen Wörter addiert wird, die in den ersten Speichern Nr. 1 bis i - 1 (60) seit dem letzten Lesen eines Wortes im ersten Speicher Nr. i (60) gelesen worden sind;
-- eine hypothetische Absolutadresse für das erste noch nicht gelesene Wort in jedem ersten Speicher Nr. i (60), mit i = 1 bis n, zu berechnen, indem dessen hypothetische Relativadresse und die Absolutadresse des letzten Wortes, das vorher im ersten Speicher Nr. i (60) gelesen worden ist, addiert werden;
- Mittel (41, 42) für die Wahl einer sogenannten endgültigen Absolutadresse, die die hypothetische Absolutadresse mit dem minimalen Wert der n Adressen ist, die von den vorhergehenden Mitteln (38, 40) geliefert werden, indem eventuell diejenige gewählt wird, die dem ersten Speicher (60) mit der Kleinsten Nummer entspricht, falls mehrere Wörter mit einer hypothetischen Absolutadresse, die gleich dem minimalen Wert ist, vorhanden sind;
- Mittel (34), mit denen in dem der endgültigen Absolutadresse entsprechenden ersten Speicher das dieser endgültigen Absolutadresse entsprechende Wort gelesen wird und mit denen dieses in einem dritten Speicher (42) in der Reihenfolge ansteigender Absolutadressen gespeichert wird, um einen Block von Wörtern wiederherzustellen.
